# EUROPÄISCHE PATENTSCHRIFT

(11) **EP 2 494 265 B1**
(45) Veröffentlichungstag und Bekanntmachung des Hinweises auf die Patenterteilung: **02.07.2014**
(21) Anmeldenummer: 10787725.0
(22) Anmeldetag: 26.11.2010
(51) Int. Cl.: F21S 4/00, F21Y 101/02, F21V 23/06, H02G 1/12

(54) **VERFAHREN ZUM KONTAKTIEREN EINER LEUCHTVORRICHTUNG, WERKZEUG ZUM DURCHFÜHREN DES VERFAHRENS UND ANSCHLUSSELEMENT ZUM AUFSATZ AUF EINE LEUCHTVORRICHTUNG**
METHOD FOR CONTACTING A LIGHTING DEVICE, TOOL FOR PERFORMING THE METHOD AND CONNECTION ELEMENT FOR ATTACHMENT ON A LIGHTING DEVICE
PROCÉDÉ POUR METTRE EN CONTACT UN DISPOSITIF D'ÉCLAIRAGE, OUTIL POUR METTRE EN OEUVRE LE PROCÉDÉ ET ÉLÉMENT DE RACCORDEMENT À POSER SUR UN DISPOSITIF D'ÉCLAIRAGE

(30) Priorität: 10.12.2009 DE 102009054511
(43) Veröffentlichungstag der Anmeldung: 05.09.2012
(73) Patentinhaber: OSRAM GmbH, 80807 München (DE)
(72) Erfinder: KAMPFRATH, Andreas, 89168 Niederstrotzingen (DE); STRAUSS, Steffen, 93152 Nittendorf (DE)
(86) Internationale Anmeldenummer: PCT/EP2010/068315
(87) Internationale Veröffentlichungsnummer: WO 2011/069844

(56) Entgegenhaltungen:
- EP-A1- 1 124 297
- EP-A2- 0 760 448
- EP-A2- 0 911 573
- DE-U1- 20 315 756
- US-A- 3 960 430
- US-A- 4 173 035
- US-A- 5 559 681

## Beschreibung

Die Erfindung betrifft ein Verfahren zum Kontaktieren einer Leuchtvorrichtung, wobei die Leuchtvorrichtung eine Leiterplatte aufweist, welche zumindest teilweise von einer Vergussschicht bedeckt ist; wobei die Leuchtvorrichtung an einer Trennstelle in zwei Leuchtvorrichtungsabschnitte auftrennbar ist und jeder der Leuchtvorrichtungsabschnitte benachbart zu der Trennstelle jeweils mindestens einen elektrischen Kontakt aufweist. Die Erfindung betrifft auch ein Werkzeug zum Durchführen des Verfahrens.

Es sind in mehrere Abschnitte trennbare flexible LED-Bänder bekannt, z.B. der LINEARLight-Serie der Fa. Osram, welche in einem bandförmigen U-Profil aus Silikon eingelegt sind und in dem Profil mit einer Vergussmasse aus Silikon vergossen sind. Hierbei werden zur Kontaktierung der aufgetrennten LED-Bandabschnitte deren stirnseitige Kontakte freigelegt und kontaktiert. Bei der Kontaktierung mit einem Kontaktierungselement kann eine Abdichtung des LED-Bands oder LED-Bandabschnitts so weit entfernt sein, dass eine Schutzfunktion oder Schutzklasse beeinträchtigt wird. Um die Schutzfunktion oder Schutzklasse aufrecht zu erhalten, ist es bekannt, das Kontaktierungselement nachträglich mit Silikon zu vergießen, was aufwändig ist.

EP0911573 offenbart ein in mehrere Abschnitte trennbares flexibles LED-Band. Die Abschnitte können an geeigneten Trennstellen abgetrennt werden. An den Trennstellen können Kontaktstifte in eine Stirnseite des abgetrenriten Abschnittes eirigesteckt werden. DE20315756U offenbart eine Abisolierzange für Flachkabel.

Alternativ sind vergossene LED-Bänder mit mitvergossenen Steckverbindern bekannt. Dabei tritt der Nachteil auf, dass dies eine Flexibilität bei einer Längenkonfektionierung herabsetzt und vergleichsweise teuer ist.

Es ist die **Aufgabe** der vorliegenden Erfindung, die Nachteile des Standes der Technik zumindest teilweise zu beseitigen und insbesondere eine Möglichkeit für eine einfache Kontaktierung vergossener Leuchtbänder bereitzustellen, welche eine Schutzfunktion aufrechterhalten kann.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch ein Verfahren zum Kontaktieren einer Leuchtvorrichtung, wobei die Leuchtvorrichtung eine Leiterplatte aufweist, welche zumindest teilweise von einer Vergussschicht bedeckt ist; wobei die Leuchtvorrichtung an einer Trennstelle in zwei Leuchtvorrichtungsabschnitte auftrennbar ist und jeder der Leuchtvorrichtungsabschnitte benachbart zu der Trennstelle jeweils mindestens einen elektrischen Kontakt aufweist; wobei das Verfahren mindestens die folgenden Schritte aufweist:
- Entfernen zumindest der Vergussschicht beidseitig der Trennstelle über die benachbarten Kontakte der Leuchtvorrichtungsabschnitte hinaus so, dass die Kontakte von einer dünneren, restlichen Vergussschicht bedeckt bleiben;
- Auftrennen der Leuchtvorrichtung an der Trennstelle;
- Befestigen eines Anschlusselements zumindest auf der restlichen Vergussschicht zumindest eines der Leuchtvorrichtungsabschnitte,
- wobei das Anschlusselement mindestens ein Kontaktierungselement aufweist, welches einen jeweiligen mit der restlichen Vergussschicht bedeckten Kontakt nach einem Durchtrennen oder Durchstoßen der restlichen Vergussschicht kontaktiert.

Durch dieses Verfahren sind die Kontakte aufgrund der dünne(re)n restlichen Vergussschicht leicht erreichbar und mittels des Durchstoßens ohne weiteren Aufwand kontaktierbar. Die restliche Vergussschicht wirkt zudem gegenüber dem Kontaktierungselement als eine Abdichtung, so dass auf einen zusätzlichen Abdichtungsschritt (z.B. durch ein Vergießen) verzichtet werden kann.

Das Anschlusselement dient dem elektrischen Anschluss der Leiterplatte zur Energieübertragung und/oder Datenübertragung.

Unter einem elektrischen Kontakt der Leiterplatte kann jegliche für eine externe Kontaktierung geeignete Stelle der Verdrahtung verwendet werden, z.B. eine ausreichend breite Leiterbahn oder ein speziell zur Kontaktierung vorgesehener Kontaktbereich wie ein Kontakthöcker oder ein Kontaktfeld ("Kontaktpad") usw.

Es ist eine Ausgestaltung, dass zumindest die Vergussschicht mittels zweier im Wesentlichen senkrechter Schnitte in dem Bereich beidseitig der Trennstelle über die Kontakte hinaus eingeschnitten wird (insbesondere bis zu der Leiterplatte) und zumindest zwischen den vertikalen Schnitten zusätzlich mittels mindestens eines horizontalen Schnitts auf einer Höhe oberhalb der Kontakte seitlich durchtrennt wird. So kann die Leuchtvorrichtung mit einfachen Mitteln präpariert werden.

Es ist noch eine Ausgestaltung, dass die Leiterplatte und die Vergussschicht in einem Profil aufgenommen sind und zumindest ein Teil des Profils beidseitig der Trennstelle zusammen mit der Vergussschicht entfernt wird, vorzugsweise im Rahmen der gleichen Trennschritte. Das Profil kann dabei ebenfalls nur oberhalb der Kontakte entfernt werden, was besonders einfach und schnell durchführbar ist. Alternativ kann das Profil beispielsweise in dem durch die senkrechten Schnitte begrenzten Bereich vollständig entfernt werden, um eine kompakte Form des Anschlusselements zu ermöglichen. Auch kann das Anschlusselement so unterseitig direkt an die Leiterplatte aufgesetzt werden.

Es ist zudem eine Ausgestaltung, dass das Anschlusselement zumindest auf einen Teil der restlichen Vergussschicht aufgesetzt wird und für eine elektrische Verbindung zu dem Kontakt die über dem Kontakt befindliche restliche Vergussschicht mittels eines elektrischen Kontaktierungselements durchstößt. Insbesondere kann das Anschlusselement auf die gesamte restliche Vergussschicht und optional zusätzlich auf die nicht heruntergedünnte Vergussschicht aufgesetzt werden, um einen Grad an Dichtigkeit weiter zu erhöhen.

Es ist ferner eines Ausgestaltung, dass das Kontaktierungselement eine Schneidkante zum schneidenden oder durchstoßenden Trennen der restlichen Vergussschicht aufweist. Dadurch wird eine Kontaktierung erleichtert.

Das Anschlusselement kann insbesondere ein Steckverbinder sein.

Es ist noch eine Ausgestaltung, dass das Kontaktierungselement sich teilweise in einer Steckeraufnahme befindet und zumindest bei einem ersten Einstecken eines Steckstifts in die Steckeraufnahme das Kontaktierungselement mittels des Steckstifts durch die restliche Vergussschicht hindurch auf den Kontakt gedrückt wird. Dadurch kann ein hoher Kontaktdruck und folglich eine sichere Kontaktierung erreicht werden.

Es ist noch eine weitere Ausgestaltung, dass das Kontaktierungselement bei einer Aufsatzbewegung des Anschlusselements durch die restliche Vergussschicht hindurch auf den Kontakt gedrückt wird.

Es ist eine Weiterbildung, dass die Aufsatzbewegung des Anschlusselements eine Gleitbewegung umfasst. Dadurch kann der mindestens eine elektrische Kontakt beispielsweise bei einem Aufschieben des Anschlusselements auf die Leuchtvorrichtung kontaktiert werden.

Es ist noch eine Weiterbildung, dass die Aufsatzbewegung des Anschlusselements eine senkrechte Aufsatzbewegung umfasst. Dadurch kann der mindestens eine elektrische Kontakt beispielsweise bei einem Aufdrücken des Anschlusselements auf die Leuchtvorrichtung kontaktiert werden. So kann hierbei beispielsweise das Verbindungselement zweiteilig ausgeführt sein, wobei die beiden Teile an der Leuchtvorrichtung angesetzt und danach unter einem Druck verrastet werden. Der Rastvorgang stellt dabei die senkrechte Aufsatzbewegung bereit. Alternativ oder zusätzlich kann der elektrische Kontakt durch Clipsen, Klemmen, Verschrauben usw. kontaktiert und/oder befestigt werden.

Es ist noch eine weitere Ausgestaltung, dass die Leiterplatte eine bandförmige Leiterplatte, insbesondere bandförmige flexible Leiterplatte, ist. Diese lässt sich besonders einfach mittels des genannten Verfahrens kontaktieren, insbesondere in einem Bereich längsseitiger Enden.

Es ist noch eine weitere Ausgestaltung, dass das Vergussmaterial ein elastisches Grundmaterial ausweist, insbesondere Silikon. Dadurch kann eine mechanische Flexibilität der Leuchtvorrichtung, insbesondere Leuchtbands, zumindest eingeschränkt aufrechterhalten werden.

Die Aufgabe wird auch gelöst durch ein Werkzeug zum Durchführen des Verfahrens, wobei das Werkzeug eine Schneidzange mit einer senkrecht stehenden Doppelschneide und einer horizontal beweglichen Schneide ist. So kann der Schritt des Entfernens zumindest der Vergussschicht einfach und innerhalb eines einzigen Ablaufschritts durchgeführt werden.

Die Aufgabe wird ferner gelöst durch ein Anschlusselement zum Aufsatz auf eine Leuchtvorrichtung, wobei der Steckverbinder mindestens ein Kontaktierungselement zum Durchtrennen oder Durchstoßen einer restlichen Vergussschicht aufweist.

Es ist eine Weiterbildung, dass das Kontaktierungselement eine Schneidkante aufweist. Dies erleichtert eine Durchtrennung oder Durchstoßung der restlichen Vergussschicht.

Die Leuchtvorrichtung kann dazu insbesondere eine mit einer Vergussschicht bedeckte Leiterplatte aufweisen, wobei die Leuchtvorrichtung mindestens einen Bereich mit einer dünneren restlichen Vergussschicht aufweist, wobei mindestens ein elektrischer Kontakt von der restlichen Vergussschicht bedeckt ist.

Durch die Erfindung wird insbesondere erreicht, dass:
- eine Trennung von vergossenen Leiterplatten, insbesondere flexiblen Leuchtbändern, kundenseitig möglich ist, evtl. mit Spezialwerkzeug;
- eine einfache, dichte Montage eines Anschlusselements, insbesondere Steckverbinders, durch einen Kunden ohne Verlust der IP-Klassifizierung möglich ist,
- eine kundenseitige Längenkonfektionierung leicht erfolgen kann
- kein nennenswerter Verlust der Biegbarkeit flexibler Leiterplatten auftritt,
- das die Anschlusselemente mit anderen Systemen kombinierbar sind,
- die Fertigung (insbesondere ein Vergussschritt) vereinfacht wird, da nicht in diskreten Längen gefertigt werden muss, sondern quasi endlos gefertigt werden kann.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt als Schnittdarstellung in Seitenansicht einen Ausschnitt aus einem trennbaren Leuchtband;
- Fig.2: zeigt das trennbare Leuchtband als Schnittdarstellung in Vorderansicht;
- Fig.3: zeigt als Schnittdarstellung in Seitenansicht das Leuchtband mit einer beidseitig einer Trennstelle entfernten Vergussschicht;
- Fig.4: zeigt in Seitenansicht ein mögliches Werkzeug zum Entfernen der Vergussschicht;
- Fig.5: zeigt als Schnittdarstellung in Seitenansicht einen Leuchtbandabschitt im Bereich eines abgetrennten Endes;
- Fig.6: zeigt einen Leuchtbandabschnitt mit einem daran endseitig montierten Steckverbinder gemäß einer ersten Ausführungsform;
- Fig.7: zeigt einen Leuchtbandabschnitt mit einem daran endseitig montierten Steckverbinder gemäß einer zweiten Ausführungsform; und
- Fig.8: zeigt einen Leuchtbandabschnitt mit einem daran endseitig montierten Steckverbinder gemäß einer dritten Ausführungsform.

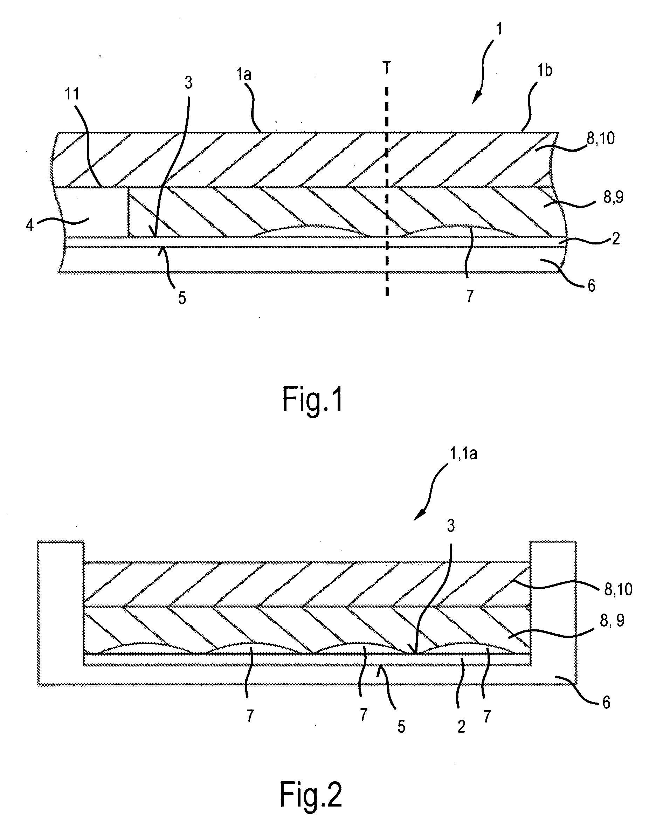

**Fig.1** zeigt als Schnittdarstellung in Seitenansicht einen Ausschnitt aus einem erfindungsgemäßen Leuchtband 1. **Fig.2** zeigt das Leuchtband 1 als Schnittdarstellung in Vorderansicht.

Bezug nehmend auf Fig.1 und Fig.2 weist die in Form eines Leuchtbands 1 vorliegende Leuchtvorrichtung eine bandförmige, flexible Leiterplatte 2 auf, deren Oberseite oder Vorderseite 3 mit in Reihe angeordneten Leuchtdioden 4 bestückt ist. Eine Rückseite 5 der Leiterplatte 2 ist auf einem Boden eines länglichen, im Querschnitt U-förmigen Profils 6 (siehe Fig.2) befestigt. Das Profil 6 kann Silikon als sein Grundmaterial aufweisen, um eine Biegsamkeit des Leuchtbands 1 zumindest teilweise beibehalten zu können. Das Profil 6 kann insbesondere aus einem blickdichten Material bestehen. Die Leuchtdioden 4 strahlen nach oben aus der offenen Seite des Profils 6 hinaus, wobei das Profil 6 die bestückte Leiterplatte 2, 4 nach oben überragt.

An der Vorderseite 3 der Leiterplatte 2 befindet sich eine Verdrahtung für daran befestigte Elemente (Leuchtdioden 4 und ggf. weitere elektronische Bauelemente wie Treiberbausteine, Kondensatoren und/oder Widerstände), wobei von der Verdrahtung nur elektrische Kontakte 7 gezeigt sind. Die elektrischen Kontakte 7 können sich beispielsweise beidseitig einer Trennstelle T befinden, an welcher das Leuchtband 1 bzw. die vergossene Leiterplatte 2, 4, 8 in zwei Leuchtbandabschnitte 1a, 1b trennbar und somit konfektionierbar ist.

Die bestückte Leiterplatte 2, 4 ist mit einer Vergussschicht 8 innerhalb des Profils 6 vergossen, welche aus zwei übereinanderliegenden Vergusslagen 9, 10 besteht. Eine untere erste Vergusslage 9, welche zuerst aufgebracht worden ist, bedeckt die Leiterplatte 2 bis zu einer Oberseite 11 der Leuchtdioden 4. Die Oberseite 11 ist nicht durch die erste Vergusslage 9 bedeckt und weist den Lichtaustrittsbereich der Leuchtdiode 4 auf. Das Profil 6 und die erste Vergusslage 9 schützen die bestückte Leiterplatte 2,4 bis auf die Höhe der Oberseite(n) 11 der Leuchtdiode(n) 4, z.B. zur Erfüllung einer IP-Klasse.

Die erste Vergusslage 9 ist lichtundurchlässig und für eine farblich einheitliche Anmutung in der gleichen Farbe ausgebildet wie das Profil 6. Dies kann z.B. durch einen Farbzusatz (farbige Füllpartikel usw.) zu einem ansonsten nichtfarbigen Grundmaterial erreicht werden. So bleibt die bestückte Leiterplatte 2,4 bis auf die jeweilige Oberseite 11 der Leuchtdiode(n) 4 einem Blick von Außen entzogen. Die erste Vergusslage 9 kann Silikon als Grundmaterial aufweisen, um eine gute Verarbeitbarkeit mit hohem Schutz, guter Alterungsbeständigkeit und einer Biegsamkeit bereitzustellen. Auch tritt gegenüber dem Material des Profils 6 keine Fehlanpassung auf, und es wird eine sehr gute Verbindung damit erreicht.

Zum Schutz auch der Oberseite 11 der Leuchtdiode(n) 4 ist auf der ersten Vergusslage 9 eine zweite, nun transparente oder hochgradig lichtdurchlässige Vergusslage 10 mit einer hohen Transmissivität aufgebracht, z.B. aus Silikon ohne Farbzusatz. Durch die zweite Vergusslage 10 wird die bestückte Leiterplatte 2, 4 vollständig vergossen und somit geschützt. Die zweite Vergusslage 10 weist vorteilhafterweise das gleiche Grundmaterial auf wie die erste Vergusslage 9.

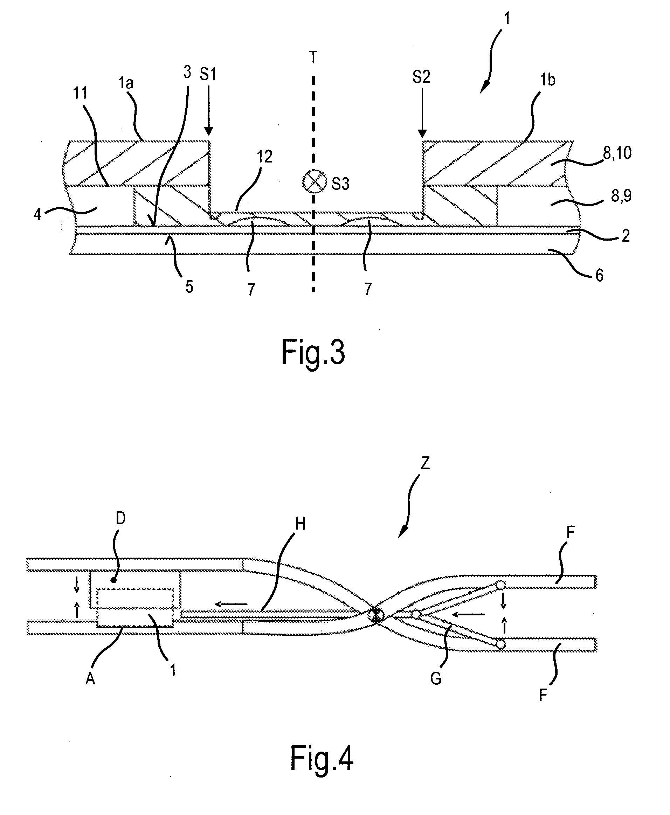

**Fig.3** zeigt das Leuchtband 1, bei dem die Vergussschicht 8 beidseitig der Trennstelle T über die benachbarten Kontakte 7 der Leuchtbandabschnitte 1a, 1b hinaus so entfernt worden ist, dass die Kontakte 7 immer noch von einer dünneren, restlichen Vergussschicht 12 bedeckt sind.

Die Vergussschicht 8 kann beispielsweise entfernt werden, indem zunächst das Leuchtband 1 beidseitig der Kontakte 7 mit jeweiligen senkrechten Schnitten S1 und S2 versehen wird, wie durch die nach unten zeigenden Pfeile angedeutet. Diese senkrechten Schnitte S1 und S2 trennen die Vergussschicht 8 und das Profil 6 maximal bis zu der Leiterplatte 2 auf. Innerhalb des durch die beiden senkrechten Schnitte S1 und S2 begrenzten Bereichs befinden sich die der Trennstelle T benachbarten Kontakte 7. Die senkrechten bzw. vertikalen Schnitte S1 und S2 werden vorzugsweise symmetrisch zu der Trennstelle gesetzt.

Gleichzeitig oder folgend wird das Leuchtband 1 (d.h., dessen Vergussschicht 8 und Profil 6) zumindest in dem durch die beiden senkrechten Schnitte S1 und S2 begrenzten Bereich durch einen horizontalen Schnitt S3 auf einer Höhe durchtrennt, welche höher ist als eine Höhe der elektrischen Kontakte 7. Dadurch verbleibt die dünnere restliche Vergussschicht 12 auf den Kontakten 7.

Zur mechanisch einfachen und präzisen Trennung können die Vergussschicht 8 und das Profil 6 vor einem Einbringen der Schnitte S1 bis S3 zeitweilig erstarrt oder versprödet werden, z.B. durch ein Aufbringen eines Kältesprühmittels, flüssigen Stickstoffs usw.

**Fig.4** zeigt in Seitenansicht ein mögliches Werkzeug zum Entfernen der Vergussschicht 8 und des Profils. Das Werkzeug ist als eine Schneidzange Z ausgebildet, welche einen Wirkbereich mit einer Doppelschneide D mit zwei parallelen, senkrecht ausgerichteten Einzelschneiden aufweist, welche dazu vorgesehen sind, die senkrechten Schnitte S1 und S2 in das Leuchtband 1 einzubringen. Für eine entsprechende Positionierung des Leuchtbands 1 weist der der Doppelschneide D entgegengesetzte Schenkel des Zangenkopfs eine Aufnahme A für das Leuchtband 1 auf. Zusätzlich weist die Schneidzange Z eine horizontal bewegliche Schneide H auf, welche zur Einbringung des horizontalen Schnitts S3 vorgesehen ist. Die horizontal bewegliche Schneide H kann über ein Schubgestänge G an den Griffen F der Schneidzange Z angelenkt sein.

Bei einer Betätigung der Schneidzange Z durch ein Zusammendrücken der Griffe F bewegt sich die Doppelschneide D auf das Leuchtband 1 zu, schneidet in dieses ein und erzeugt so die senkrechten Schnitte S1 und S2. Gleichzeitig wird die horizontal bewegliche Schneide H nach vorne geschoben, schneidet seitlich und horizontal in das Leuchtband 1 ein und erzeugt so den horizontalen Schnitt S3. Dabei wird eine Verkippung des Leuchtbands 1 durch die Doppelschneide D verhindert.

Zur korrekten Positionierung der Schneidzange Z bezüglich der Trennstelle T des Leuchtbands 1 kann das Leuchtband 1 eine oder mehrere entsprechende Markierungen (o.Abb.) aufweisen.

Im Folgenden kann das ausgeschnittene Material entfernt werden, und es können die durch die Schnitte S1 bis S3 entstandenen Schnittstellen gesäubert und/oder entgratet werden.

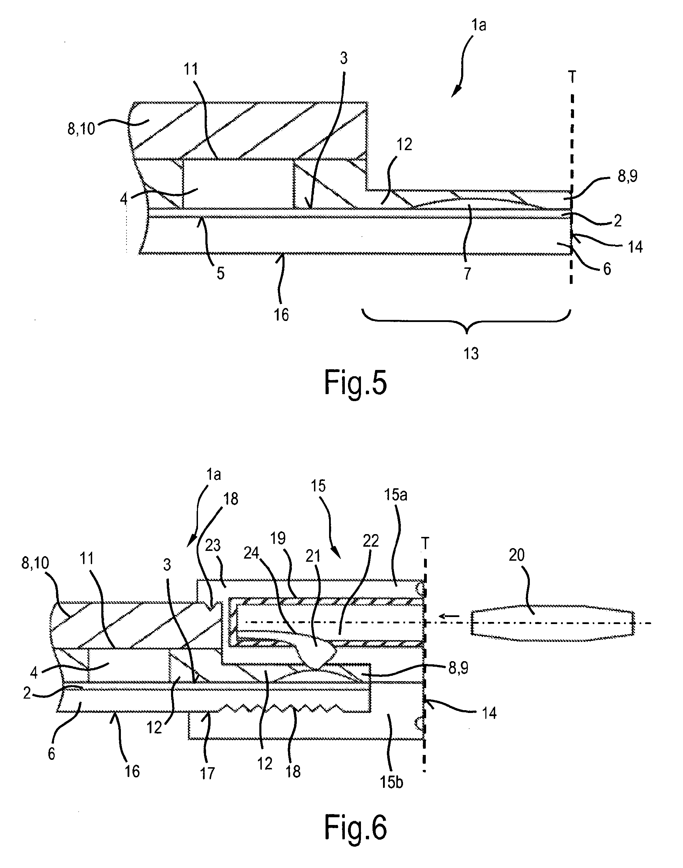

**Fig.5** zeigt einen Ausschnitt aus dem Leuchtbandabschnitt 1a in einem Bereich seines längsseitigen Endes 13, welches durch ein Auftrennen oder Durchtrennen des Leuchtbands 1 entlang der Trennstelle T folgend auf das Entfernen der Vergussschicht 8 und des Profils 6 gebildet worden ist. An dem Ende 13 bzw. in einer geringen Entfernung von einer zugehörigen Schnittkante 14 befinden sich die Kontakte 7, die von der restlichen Vergussschicht 12 bedeckt sind. An der Schnittkante 14 ist eine offene Kupferschnittkante vorhanden, welche aufgrund durchtrennter Leiterbahnen gebildet wird.

**Fig.6** zeigt den Ausschnitt aus dem Leuchtbandabschnitt 1a aus Fig.5, wobei nun auf der restlichen Vergussschicht 12 ein Anschlusselement in Form eines Steckverbinders 15 gemäß einer ersten Ausführungsform aufgebracht worden ist. Der Steckverbinder 15 ist zweiteilig aus einem oberen Steckverbinderteil 15a und einem unteren Steckverbinderteil 15b aufgebaut oder zusammengesetzt.

Das untere Steckverbinderteil 15b wird so von unten im Bereich des Endes 13 an eine Rückseite 16 des Leuchtbandabschnitts 1a angelegt, so dass das untere Steckverbinderteil 15b dort außer der Rückseite 16 auch einen unteren Teil der Schnittkante 14 abdeckt. Damit das untere Steckverbinderteil 15b und der Steckverbinder 15 nicht von dem Ende 13 abgezogen werden können, ist das untere Steckverbinderteil 15b an seiner Kontaktfläche 17 mit der Rückseite 16 mit einer Strukturierung, hier: einer Riffelung bzw. Schneidlippen 18, versehen, welche sich in die Rückseite 16, die durch das Profil 6 aus dem Silikon gebildet wird, eindrücken können. Durch diese Schneidlippen 18 kann eine Abdichtung des Steckverbinders 15 an dem Leuchtbandabschnitt 1a erreicht werden, was eine Schutzklassifikation weiter verbessern kann. Dazu schneiden bzw. drücken die Schneidlippen 18 in das Material des Profils 6 ein und bilden eine Dichtung durch eine Verwölbung des Vergussmaterials (z.B. Silikon).

Von oben wird das obere Steckverbinderteil 15a vollflächig auf die restliche Vergussschicht 12 aufgesetzt, wobei das obere Steckverbinderteil 15a die Schnittkante 14 umgreift, um deren oberen Teil, welcher nicht durch das untere Steckverbinderteil 15b abgedeckt ist, abzudecken. An einem von dem Ende 13 bzw. der Schnittkante 14 wegzeigenden Rand kontaktiert das obere Steckverbinderteil 15a die nicht entfernte Vergussschicht 8 und weist an dieser Kontaktfläche ebenfalls eine Kerbe oder Schneidlippe 18 auf, um ein Lösen auch des oberen Steckverbinderteils 15a bzw. des Steckverbinders 15 von dem Leuchtbandabschnitt 1a zu verhindern.

Zur Montage des Steckverbinders 15 werden das obere Steckverbinderteil 15a und das untere Steckverbinderteil 15b zusammengedrückt und dabei verrastet, z.B. mittels Rasthaken.

Der Steckverbinder 15 ist hier in Form einer weiblichen Buchse ausgebildet und weist zur Aufnahme eines Steckerstifts 20 eine stirnseitig offene Steckeraufnahme 19 auf. In der Steckeraufnahme 19 befindet sich ein Anschlussstift oder Kontaktstift 21, welcher durch eine Öffnung 22, z.B. einen Schlitz, in der Steckeraufnahme 19 und einem Gehäuse 23 des oberen Steckverbinderteils 15a nach unten bzw. in Richtung der restlichen Vergussschicht 12 ragen kann. Der Kontaktstift 21 kann vor einem ersten Gebrauch (Einführen des Steckerstifts 20) bereits ansatzweise durch die Öffnung 22 ragen oder noch nicht durch die Öffnung 22 ragen. Mit Einführen des Steckerstifts 20 (wie durch den Pfeil angedeutet) trifft dieser auf eine Oberseite 24 des Kontaktstifts 21 und drückt diesen nach unten durch die Öffnung 22 und weiter durch die restliche Vergussschicht 12 bis auf den zugehörigen Kontakt 7. Der Kontaktstift 21 durchstößt also dabei die restliche Vergussschicht 12. Der Steckerstift 20 kann somit den Kontakt 7 über den Kontaktstift 21 kontaktieren. Fig.6 zeigt den Kontaktstift 21, wie er den Kontakt 7 kontaktiert, nur zur besseren Übersichtlichkeit mit dem Steckerstift 20 nicht eingesteckt. Der Kontaktstift 21 kann zum einfachen Durchstoßen der restlichen Vergussschicht 12 und Eindringen in den Kontakt 7 an seiner unteren Seite eine Schneidkante aufweisen und also als ein Schneidkontakt ausgebildet sein.

Der Kontaktstift 21 ist federnd gelagert oder elastisch verformbar, um ein Brechen oder eine Beschädigung durch eine plastische Verformung zu vermeiden.

Die restliche Vergussschicht 12 dient als Dichtmaterial für den Steckverbinder 15, insbesondere als eine Dichtung für den Kontaktstift 21.

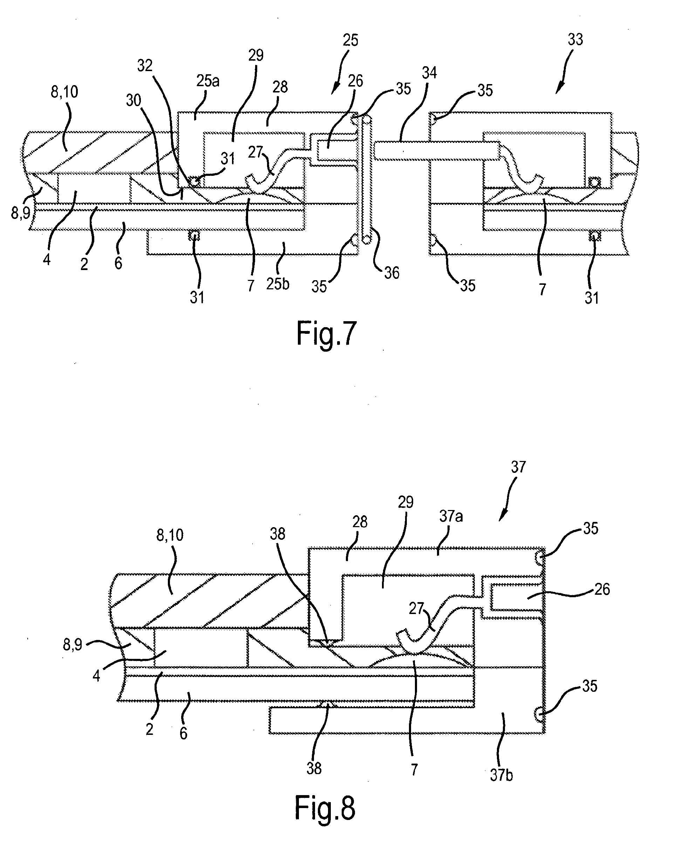

**Fig.7** zeigt den Ausschnitt aus dem Leuchtbandabschnitt 1a aus Fig.5, wobei nun auf der restlichen Vergussschicht 12 ein weiblicher Steckverbinder 25 gemäß einer zweiten Ausführungsform aufgebracht worden ist. Ein oberes Steckverbinderteil 25a des Steckverbinders 25 weist nun eine Steckeraufnahme 26 auf, in welcher kein Kontaktstift angeordnet ist. Vielmehr schließt sich der Kontaktstift 27 an einer Rückseite der Steckeraufnahme 26 an und ragt nach unten über ein Gehäuse 28 des oberen Steckverbinderteils 25a hinaus. Dazu ist der Kontaktstift 27 in einem nach unten offenen Gehäuseraum 29 untergebracht, in dem er sich bewegen kann. Das Gehäuse 28 ist an seinem rückwärtigen Kontaktrand 30 nun nicht mit einer Schneidlippe o.ä. aufgerüstet, sondern weist für eine Abdichtung ein Dichtelement 31 auf, das in einer entsprechenden Nut 32 eingesetzt ist. Ein unteres Steckverbinderteil 25b des Steckverbinders 25 gleicht dem unteren Steckverbinderteil 15b, außer dass auch hier statt einer Schneidlippe ein Dichtelement 31 zur Abdichtung verwendet wird.

Zur Montage des Steckverbinders 25 können wie bei der ersten Ausführungsform das obere Steckverbinderteil 25a und das untere Steckverbinderteil 25b an dem ersten Leuchtbandabschnitt 1a angesetzt und dann verbindend zusammengepresst werden, z.B. verrastet und/oder verklebt werden. Auch hier weist der Kontaktstift 27 eine untere Schneidkante auf, so dass er bei der Montage in die restliche Vergussschicht 12 einschneidet und den Kontakt 7 kontaktiert.

Der Steckverbinder 25 kann auch einstückig aufgeführt sein und z.B. auf den ersten Leuchtbandabschnitt 1a aufgeschoben werden.

Der passende, an dem zweiten Leuchtbandabschnitt 1b montierte männliche Steckverbinder 33 ist gleichartig zu dem Steckverbinder 25 aufgebaut, außer dass statt der Steckeraufnahme 26 ein Steckerstift 34 vorhanden sein wird. Beide Steckverbinder 25 und 33 weisen stirnseitig eine umlaufende Ringnut 35 zur Aufnahme eines O-Rings 36 auf.

**Fig.8** zeigt einen ersten Leuchtbandabschnitt 1a mit einem daran endseitig montierten weiblichen Steckverbinder 37 gemäß einer dritten Ausführungsform. Der weibliche Steckverbinder 37 (und z.B. auch das männliche Gegenstück, o.Abb.) unterscheidet sich von dem Steckverbinder 25 lediglich dadurch, dass anstelle eines separaten Dichtelements 31 eine an dem Gehäuse 28 befestigte Dichtlippe 38 verwendet wird.

Selbstverständlich ist die vorliegende Erfindung nicht auf die gezeigten Ausführungsbeispiele beschränkt.

So kann im Bereich des längsseitigen Endes eines Leuchtbands oder Leuchtbandabschnitts das Profil vollständig entfernt werden, so dass die Steckverbinder von unten die Leiterplatte kontaktieren.

### Bezugszeichenliste

- 1: Leuchtband
- 1a: Leuchtbandabschnitt
- 1b: Leuchtbandabschnitt
- 2: Leiterplatte
- 3: Vorderseite
- 4: Leuchtdiode
- 5: Rückseite
- 6: Profil
- 7: elektrischer Kontakt
- 8: Vergussschicht
- 9: erste Vergusslage
- 10: zweite Vergusslage
- 11: Oberseite der Leuchtdiode
- 12: restliche Vergussschicht
- 13: längsseitiges Ende
- 14: Schnittkante
- 15: Steckverbinder
- 15a: oberes Steckverbinderteil
- 15b: unteres Steckverbinderteil
- 16: Rückseite
- 17: Kontaktfläche
- 18: Schneidlippe
- 19: Steckeraufnahme
- 20: Steckerstift
- 21: Kontaktstift
- 22: Öffnung
- 23: Gehäuse des oberen Steckverbinderteils
- 24: Oberseite des Kontaktstifts
- 25: Steckverbinder
- 25a: oberes Steckverbinderteil
- 25b: unteres Steckverbinderteil
- 26: Steckeraufnahme
- 27: Kontaktstift
- 28: Gehäuse
- 29: Gehäuseraum
- 30: Kontaktrand
- 31: Dichtelement
- 32: Nut für das Dichtelement
- 33: Steckverbinder
- 34: Steckerstift
- 35: Ringnut
- 36: O-Ring
- 37: Steckverbinder
- 38: Dichtlippe
- A: Aufnahme
- D: Doppelschneide
- F: Griff
- G: Schubgestänge
- H: horizontal bewegliche Schneide
- S1: senkrechter Schnitt
- S2: senkrechter Schnitt
- S3: horizontaler Schnitt
- T: Trennstelle
- Z: Schneidzange

## Patentansprüche

1. Verfahren zum Kontaktieren einer Leuchtvorrichtung (1, 1a, 1b), wobei
- die Leuchtvorrichtung (1) eine Leiterplatte (2) aufweist, welche zumindest teilweise von einer Vergussschicht (8) bedeckt ist; wobei
- die Leuchtvorrichtung (1) an einer Trennstelle (T) in zwei Leuchtvorrichtungsabschnitte (1a, 1b) auftrennbar ist und
- jeder der Leuchtvorrichtungsabschnitte (1a, 1b) benachbart zu der Trennstelle (T) jeweils mindestens einen elektrischen Kontakt (7) aufweist;
wobei das Verfahren mindestens die folgenden Schritte aufweist:
- Entfernen zumindest der Vergussschicht (8) beidseitig der Trennstelle (T) über die benachbarten Kontakte (7) der Leuchtvorrichtungsabschnitte (1a, 1b) hinaus so, dass die Kontakte (7) von einer dünneren, restlichen Vergussschicht (12) bedeckt bleiben;
- Auftrennen der Leuchtvorrichtung (1) an der Trennstelle (T);
- Befestigen eines Anschlusselements (15; 25; 33; 37) zumindest auf der restlichen Vergussschicht (12) zumindest eines der Leuchtvorrichtungsabschnitte (1a, 1b),
- wobei das Anschlusselement (15; 25; 33; 37) mindestens ein Kontaktierungselement (21; 27) aufweist, welches einen jeweiligen mit der restlichen Vergussschicht (12) bedeckten Kontakt (7) nach einem Durchtrennen oder Durchstoßen der restlichen Vergussschicht (12) kontaktiert.

2. Verfahren nach Anspruch 1, wobei zumindest die Vergussschicht (8) mittels zweier im Wesentlichen senkrechter Schnitte (S1, S2) beidseitig der Trennstelle (T) über die Kontakte (7) hinaus eingeschnitten wird und zumindest zwischen den vertikalen Schnitten (S1, S2) zusätzlich mittels mindestens eines horizontalen Schnitts (S3) auf einer Höhe oberhalb der Kontakte (7) durchtrennt wird.

3. Verfahren nach einem der vorhergehenden Ansprüche, wobei die Leiterplatte (2) und die Vergussschicht (8) in einem Profil (6) aufgenommen sind und zumindest ein Teil des Profils (6) beidseitig der Trennstelle (T) zusammen mit der Vergussschicht (8) entfernt wird.

4. Verfahren nach einem der vorhergehenden Ansprüche, wobei das Anschlusselement zumindest auf einen Teil der restlichen Vergussschicht (12) aufgesetzt wird und für eine elektrische Verbindung zu dem Kontakt (7) die über dem Kontakt (7) befindliche restliche Vergussschicht (12) mittels eines Kontaktierungselements durchtrennt oder durchstößt.

5. Verfahren nach Anspruch 4, wobei das Kontaktierungselement eine Schneidkante zum Durchtrennen oder Durchstoßen der restlichen Vergussschicht (12) aufweist.

6. Verfahren nach einem der Ansprüche 4 bis 5, wobei das Anschlusselement ein Steckverbinder (15; 25; 33; 37) ist.

7. Verfahren nach Anspruch 6, wobei das Kontaktierungselement sich teilweise in einer Steckeraufnahme (19; 26) befindet und zumindest bei einem ersten Einstecken eines Steckstifts (20; 34) in die Steckeraufnahme (19; 26) das Kontaktierungselement (21) mittels des Steckerstifts (20; 34) durch die restliche Vergussschicht (12) hindurch auf den Kontakt (7) gedrückt wird.

8. Verfahren nach einem der vorhergehenden Ansprüche, wobei das Kontaktierungselement (27) bei einer Aufsatzbewegung des Anschlusselements (15; 25; 33; 37) durch die restliche Vergussschicht (12) hindurch auf den Kontakt (7) gedrückt wird.

9. Verfahren nach Anspruch 8, wobei die Aufsatzbewegung des Anschlusselements (25; 33; 37) eine Gleitbewegung umfasst.

10. Verfahren nach einem der Ansprüche 8 oder 9, wobei die Aufsatzbewegung des Anschlusselements (15) eine senkrechte Aufsatzbewegung umfasst.

11. Verfahren nach einem der vorhergehenden Ansprüche, bei dem die Leiterplatte (2) eine bandförmige Leiterplatte (2), insbesondere bandförmige flexible Leiterplatte (2), ist.

12. Verfahren nach einem der vorhergehenden Ansprüche, bei dem das Vergussmaterial (8) ein elastisches Grundmaterial ausweist, insbesondere Silikon.

13. Werkzeug zum Durchführen eines Verfahrens nach einem der vorhergehenden Ansprüche, wobei das Werkzeug eine Schneidzange (Z) mit einer senkrecht stehenden Doppelschneide (D) und einer horizontal beweglichen Schneide (H) ist.

## Claims

1. Method for contacting a lighting device (1, 1a, 1b), wherein
- the lighting device (1) has a circuit board (2), which is at least partly covered by a sealing compound layer (8); wherein
- the lighting device (1) can be separated at a separating point (T) into two lighting device portions (1a, 1b) and
- each of the lighting device portions (1a, 1b) has adjacent to the separating point (T) at least one electrical contact (7) in each case;
wherein the method comprises at least the following steps:
- removing at least the sealing compound layer (8) on both sides of the separating point (T) above the adjacent contacts (7) of the lighting device portions (1a, 1b) such that the contacts (7) remain covered by a thinner, remaining sealing compound layer (12);
- separating the lighting device (1) at the separating point (T);
- attaching a connection element (15; 25; 33; 37) at least to the remaining sealing compound layer (12) of at least one of the lighting device portions (1a, 1b),
- wherein the connection element (15; 25; 33; 37) has at least one contacting element (21; 27), which contacts a respective contact (7) covered by the remaining sealing compound layer (12) after a separation or penetration of the remaining sealing compound layer (12).

2. Method according to Claim 1, wherein at least the sealing compound layer (8) is cut into by means of two essentially vertical cuts (S1, S2) on both sides of the separating point (T) above the contacts (7) and, at least between the vertical cuts (S1, S2), is additionally separated by means of at least one horizontal cut (S3) at a height above the contacts (7).

3. Method according to one of the preceding claims, wherein the circuit board (2) and the sealing compound layer (8) are accommodated in a profile (6) and at least a part of the profile (6) is removed on both sides of the separating point (T) together with the sealing compound layer (8).

4. Method according to one of the preceding claims, wherein the connection element is placed at least onto a part of the remaining sealing compound layer (12) and, for an electrical connection to the contact (7), separates or penetrates the remaining sealing compound layer (12) located above the contact (7) by means of a contacting element.

5. Method according to Claim 4, wherein the contacting element has a cutting edge for separating or penetrating the remaining sealing compound layer (12).

6. Method according to either of Claims 4 and 5, wherein the connection element is a plug-in connector (15; 25; 33; 37).

7. Method according to Claim 6, wherein the contacting element is partly located in a connector receptacle (19; 26) and, at least during a first insertion of a plug pin (20; 34) into the connector receptacle (19; 26), the contacting element (21) is pushed by means of the plug pin (20; 34) through the remaining sealing compound layer (12) onto the contact (7).

8. Method according to one of the preceding claims, wherein, during a placing movement of the connection element (15; 25; 33; 37), the contacting element (27) is pressed through the remaining sealing compound layer (12) onto the contact (7).

9. Method according to Claim 8, wherein the placing movement of the connection element (25; 33; 37) comprises a sliding movement.

10. Method according to either of Claims 8 and 9, wherein the placing movement of the connection element (15) comprises a vertical placing movement.

11. Method according to one of the preceding claims, in which the circuit board (2) is a strip-type circuit board (2), in particular a strip-type flexible circuit board (2).

12. Method according to one of the preceding claims, in which the sealing compound material (8) comprises an elastic base material, in particular silicone.

13. Tool for carrying out a method according to one of the preceding claims, wherein the tool is a pair of cutting pliers (Z) with a vertical double cutter (D) and a horizontally movable cutter (H).

## Revendications

1. Procédé de connexion d'un dispositif d'éclairage (1, 1a, 1b),
- le dispositif d'éclairage (1) présentant une plaquette à circuit imprimé (2), laquelle est recouverte au moins en partie par une couche de scellement (8) ;
- le dispositif d'éclairage (1) étant séparable en deux sections de dispositif d'éclairage (1a, 1b) à un point de séparation (T) et
- chacune des sections de dispositif d'éclairage (1a, 1b) voisines au point de séparation (T) présentant au moins un contact électrique (7) ;
le procédé présentant au moins les étapes suivantes :
- retrait au moins de la couche de scellement (8) de chaque côté du point de séparation (T) au-delà des contacts voisins (7) des sections de dispositif d'éclairage (1a, 1b), de sorte que les contacts (7) restent recouverts par une couche de scellement résiduelle (12) plus mince ;
- séparation du dispositif d'éclairage (1) au point de séparation (T) ;
- fixation d'un élément de raccordement (15 ; 25 ; 33 ; 37) au moins sur la couche de scellement résiduelle (12) au moins de l'une des sections de dispositif d'éclairage (1a, 1b),
- l'élément de raccordement (15 ; 25 ; 33 ; 37) présentant au moins un élément de connexion (21 ; 27) lequel connecte un contact respectif (7) recouvert par la couche de scellement résiduelle (12) après une séparation ou perforation de la couche de scellement résiduelle (12).

2. Procédé selon la revendication 1, au moins la couche de scellement (8) étant entaillée au moyen de deux coupes (S1, S2) essentiellement verticales de chaque côté du point de séparation (T) au-delà des contacts (7) et étant séparée au moins entre les coupes verticales (S1, S2) en plus au moyen au moins d'une coupe horizontale (S3) à une hauteur située au-dessus des contacts (7).

3. Procédé selon l'une quelconque des revendications précédentes, la plaquette à circuit imprimé (2) et la couche de scellement (8) étant logées dans un profilé (6) et au moins une partie du profilé (6) étant retirée avec la couche de scellement (8) de chaque côté du point de séparation (T).

4. Procédé selon l'une quelconque des revendications précédentes, l'élément de raccordement étant posé au moins sur une partie de la couche de scellement résiduelle (12) et la couche de scellement résiduelle (12) se trouvant au-dessus du contact (7) étant séparée ou perforée au moyen d'un élément de connexion pour une connexion électrique vers le contact (7).

5. Procédé selon la revendication 4, l'élément de connexion présentant une arête de coupe pour séparer ou perforer la couche de scellement résiduelle (12).

6. Procédé selon l'une quelconque des revendications 4 à 5, l'élément de raccordement étant un connecteur (15 ; 25 ; 33 ; 37).

7. Procédé selon la revendication 6, l'élément de connexion se trouvant en partie dans un logement de connecteur (19 ; 26) et l'élément de connexion (21), lorsqu'une fiche de connexion (20 ; 34) est initialement enfichée dans le logement de connecteur (19 ; 26), étant pressé sur le contact (7) au moyen de la fiche de connexion (20 ; 34) en traversant la couche de scellement résiduelle (12).

8. Procédé selon l'une quelconque des revendications précédentes, l'élément de connexion (27), lors d'un mouvement de pose de l'élément de raccordement (15 ; 25 ; 33 ; 37), étant pressé sur le contact (7) en traversant la couche de scellement résiduelle (12).

9. Procédé selon la revendication 8, le mouvement de pose de l'élément de raccordement (25; 33; 37) comprenant un mouvement de glissement.

10. Procédé selon l'une quelconque des revendications 8 ou 9, le mouvement de pose de l'élément de raccordement (15) comprenant un mouvement de pose vertical.

11. Procédé selon l'une quelconque des revendications précédentes, dans lequel la plaquette à circuit imprimé (2) est une plaquette à circuit imprimé (2) en forme de bande, notamment une plaquette à circuit imprimé (2) flexible en forme de bande.

12. Procédé selon l'une quelconque des revendications précédentes, dans lequel la matière de scellement (8) présente une matière de base élastique, notamment de la silicone.

13. Outil destiné à exécuter un procédé selon l'une quelconque des revendications précédentes, l'outil étant une pince coupante (Z) munie d'une double arête de coupe (D) en position verticale et d'une arête de coupe (H) mobile horizontale.
